## Europäisches Patentamt
## European Patent Office
## Office européen des brevets

(19)

(11) Numéro de publication: **0 175 601**
**B1**

(12)

# FASCICULE DE BREVET EUROPEEN

(45) Date de publication du fascicule du brevet:
**15.03.89**

(51) Int. Cl.⁴: **C30B 25/14, C30B 31/16**

(21) Numéro de dépôt: **85401602.9**

(22) Date de dépôt: **06.08.85**

(54) **Procédé et dispositif d'obtention d'un courant gazeux contenant un composé a l'état de vapeur, utilisable notamment pour introduire ce composé dans un réacteur d'épitaxie.**

(30) Priorité: **14.08.84 FR 8412788**

(43) Date de publication de la demande:
**26.03.86 Bulletin 86/13**

(45) Mention de la délivrance du brevet:
**15.03.89 Bulletin 89/11**

(84) Etats contractants désignés:
**DE GB IT NL SE**

(56) Documents cités:
**GB-A- 1 559 978**
**US-A- 3 459 668**

**Chemical Engineers' Handbook, 5e, ed.**
**pages 17-45, 17-46, 17-48**

(73) Titulaire: **Mellet, Robert, 18, rue Chapon,**
**F-75003 Paris(FR)**

(72) Inventeur: **Mellet, Robert, 18, rue Chapon,**
**F-75003 Paris(FR)**

(74) Mandataire: **Mongrédien, André et al, c/o**
**BREVATOME 25, rue de Ponthieu, F-75008 Paris(FR)**

ACTORUM AG

## Description

La présente invention a pour objet un procédé et un dispositif d'obtention d'un courant gazeux contenant un composé à l'état de vapeur, utilisable notamment pour introduire ce composé dans un réacteur d'épitaxie en phase vapeur.

Les techniques d'épitaxie en phase vapeur sont généralement utilisées pour la fabrication de semiconducteurs et notamment de semiconducteurs du type III–V ou II–VI.

On peut en particulier employer cette technique pour former des hétérojonctions constituées par plusieurs couches de semiconducteurs de compositions différentes, dont les applications sont nombreuses, par exemple en optoélectronique (lasers, photodétecteurs) et en microélectronique (transistors ultrarapides).

Pour réaliser le dépôt par épitaxie en phase vapeur de couches de semiconducteurs composés on introduit généralement les constituants cationiques de la couche dans l'enceinte d'épitaxie sous la forme de vapeurs de leurs composés organométalliques.

Ainsi, dans le cas de semiconducteurs du type III–V tels que l'arséniure de gallium GaAs ou le phosphure d'indium InP, le taux de croissance du composé semiconducteur déposé par épitaxie en phase vapeur dépend en premier lieu, de la pression partielle des composés organométalliques contenant des constituants cationiques (Ga, In) à l'entrée de la cellule d'épitaxie.

Dans le cas des alliages semiconducteurs tels que $Ga_{1-x}In_xAs_yP_{1-y}$, la composition cationique x en phase solide dépend ainsi directement du rapport des pressions partielles des composés organométalliques correspondants selon la relation simple suivante:

$$\frac{x}{1-x} = K \frac{pGa}{pIn}$$

dans laquelle pGa et pIn sont respectivement les pressions partielles des composés organométalliques contenant le gallium et l'indium, tandis que K est une constante relativement insensible aux autres paramètres du processus tels que la tempèrature du substrat ou le débit gazeux total.

Or, dans le procédé de croissance d'alliages du type $Ga_{1-x}In_xAs_yP_{1-y}$, il est primordial de contrôler la composition x dans des limites très étroites. En effet, une variation d'environ 1% est prohibitive car elle conduit à un écart de paramètre de maille cristalline

$$\frac{\Delta a}{a}$$

d'environ $10^{-3}$, ce qui suffit généralement pour dégrader irrémédiablement les propriétés électroniques du matériau.

Aussi, dans les procédés de ce type, il est très important de pouvoir contrôler avec précision les pressions partielles des composés organométalliques introduits dans le réacteur d'épitaxie.

Jusqu'à présent, la technique habituelle pour introduire ces composés organométalliques dans le réacteur d'épitaxie, a consisté à faire barboter un gaz vecteur inerte dans le composé à l'état liquide de manière à charger le gaz vecteur au voisinage de la saturation en vapeur de ce composé. Ensuite, on dilue le gaz vecteur saturé afin d'obtenir la pression partielle souhaitée.

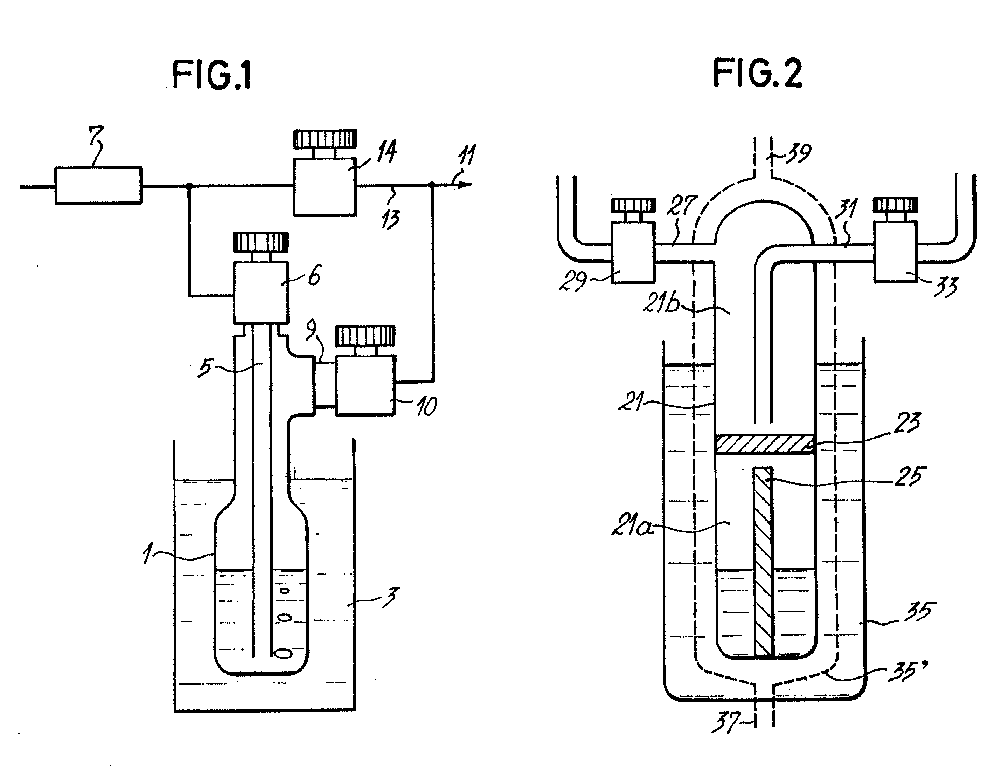

Un dispositif permettant d'obtenir de cette façon un courant gazeux contenant un composé organométallique à l'état de vapeur est illustré sur la figure 1. Ce dispositif comprend une enceinte étanche 1 contenant le composé organométallique à l'état liquide, qui peut être porté à la température voulue par un bain thermostaté 3. Un conduit 5 relié par l'intermédiaire d'une vanne 6 à une source de gaz vecteur 7 débouche dans le fond de l'enceinte 1. Le gaz vecteur introduit par le conduit 5 peut être chargé en vapeur du composé organométallique par barbotage dans le composé à l'état liquide, puis évacué de l'enceinte par un conduit 9 muni d'une vanne 10. On introduit ensuite le courant gazeux dans le réacteur d'épitaxie par la conduite 11 après l'avoir dilué à la valeur voulue par addition de gaz vecteur amené par la conduite 13 munie de la vanne 14 reliée à la source de gaz vecteur 7.

Lorsque l'on utilise un dispositif de ce type, la pression partielle du composé organométallique dans le gaz vecteur sortant par la conduite 11 dépend de plusieurs paramètres physiques qui sont:

1) la température de la source de composé organométallique dans l'enceinte 1,

2) le débit du gaz vecteur qui barbote dans la source de composé organométallique,

3) la pression en phase gazeuse au-dessus de la source de composé organométallique dans l'enceinte 1,

4) le niveau de liquide dans l'enceinte 1,

5) le débit total et la pression du gaz dans le réacteur d'épitaxie.

Parmi ces différents paramètres, seuls les derniers mentionnés, c'est-à-dire le débit total et la pression de gaz dans le réacteur d'épitaxie agissent simultanément et de la même façon sur toutes les pressions partielles des composés organométalliques introduits dans ce réacteur; de ce fait, ils ne sont pas susceptibles de modifier la composition en phase solide qui est fonction uniquement des rapports entre les différentes pressions partielles. En revanche, les quatre premiers paramètres agissent indépendamment sur chaque pression partielle et pour contrôler de façon précise la composition des alliages en phase solide, il est par conséquent nécessaire d'exercer un contrôle précis de chaque température, chaque débit de gaz vecteur et chaque pression de gaz en contact avec les sources de composés organométalliques.

Pour contrôler les débits gazeux, on utilise généralement un débitmètre régulateur massique qui est un traducteur de débit basé sur la mesure de transfert de chaleur dans le gaz, couplé par l'intermédiaire d'un circuit de régulation électronique à une vanne d'ouverture variable.

Bien que ces appareils représentent un progrès considérable par rapport aux techniques plus anciennes, telles que les débitmètres à billes, ils ont les inconvénients suivants:

— Ils sont sensibles à la température des gaz et à la température ambiante, typiquement 0,1% de la pleine échelle par °C. De ce fait des variations de quelques degrés seulement peuvent compromettre la qualité d'une épitaxie en modifiant la composition d'un alliage d'une fraction de pourcent.

— Ils sont d'un coût élevé et d'une fiabilité médiocre en raison de leur complexité.

— Ils ont des temps de réponse relativement grands (quelques secondes), donc il est difficile d'assurer la maîtrise du procédé d'épitaxie dans les régimes transitoires, par exemple l'interface entre deux couches de compositions différentes.

L'utilisation d'un dispositif de ce type présente encore d'autres inconvénients.

En effet, le gaz vecteur à la sortie de l'enceinte 1 est presque chargé en composé organométallique de sorte que, lors de son passage par une canalisation à température inférieure à celle de la source de composé organométallique, il pourra se produire un dépôt du composé organométallique. Pour éviter et minimiser cet effet fort gênant, on chauffe habituellement les canalisations et on dilue, dès que possible, le gaz vecteur, ce qui implique une complication notable de l'appareillage et entre autres le doublement du jeu de débitmètres.

Par ailleurs, ce dispositif ne peut être utilisé avec tous les composés organométalliques, car il est nécessaire que la combinaison des propriétés physiques du composé organométallique, en particulier son point de fusion et sa pression de vapeur puissent convenir pour la mise en œuvre de cette technique d'évaporation et d'introduction dans un courant gazeux.

Ainsi, certains composés peuvent présenter une tension de vapeur trop élevée aux températures proches de l'ambiante, ce qui implique de les refroidir à des températures trop basses.

D'autres composés peuvent avoir une tension de vapeur convenable mais se trouver à l'état solide aux températures proches de l'ambiante.

Bien qu'il soit possible de saturer un gaz vecteur en le faisant circuler au-dessus d'un solide qui sublime, ce procédé conduit en pratique à des résultats moins reproductibles que ceux fournis par le barbotage du gaz dans une source liquide. Aussi, il est nécessaire de sélectionner sévèrement les composés à introduire par cette technique dans le réacteur d'épitaxie.

La présente invention a précisément pour objet un procédé et un dispositif d'obtention d'un courant gazeux contenant un composé à l'état de vapeur qui permet d'éliminer les inconvénients rappelés ci-dessus et d'obtenir une meilleure précision et une meilleure reproductibilité pour l'introduction de composés gazeux dans un réacteur d'épitaxie.

Le procédé selon l'invention, d'obtention d'un courant gazeux contenant un composé à l'état de vapeur se caractérise en ce qu'il consiste:

a) à introduire le composé dans le premier compartiment d'une enceinte séparée en un premier et un second compartiment par une cloison poreuse,

b) à porter à une température déterminée le premier compartiment de l'enceinte de façon à évaporer ledit composé,

c) à mettre en circulation dans le second compartiment un gaz vecteur capable d'entraîner le composé évaporé, et

d) à extraire du second compartiment le gaz vecteur contenant le composé évaporé qui a diffusé dans le second compartiment par passage au travers de la paroi poreuse.

De préférence, selon l'invention, on amène le composé à l'état liquide au voisinage de la cloison poreuse de façon à réaliser surtout l'évaporation du composé au voisinage de cette cloison.

Selon ce procédé, on règle à la valeur voulue la pression partielle du composé à l'état de vapeur dans le gaz vecteur sortant du second compartiment en agissant sur la température à laquelle est porté le premier compartiment et sur le débit du gaz vecteur mis en circulation dans le second compartiment.

En effet, le débit de composé évaporé qui diffuse dans le second compartiment est seulement fonction:

— de paramètres fixes, caractéristiques de l'appareillage, qui sont la porosité, l'épaisseur et la section de la cloison poreuse, et

— de la température qui agit à la fois sur la tension de vapeur du composé et sur le coefficient de diffusion de la vapeur du composé dans le gaz vecteur.

Ainsi, pour un dispositif donné, la température est le seul paramètre qui permet un ajustement précis du débit de composé diffusé au travers de la cloison poreuse. Une fois ce débit fixé par le choix de la température, on peut ajuster à la valeur voulue la pression partielle du composé à l'état de vapeur dans le gaz vecteur en réglant de façon appropriée le débit du gaz vecteur mis en circulation dans le second compartiment.

Le procédé de l'invention présente ainsi de nombreux avantages:

1) Le débit du composé diffusé à l'état de vapeur est indépendant du débit du gaz vecteur du moment que celui-ci est suffisant pour entraîner la vapeur ayant diffusé au travers de la cloison; de ce fait, l'utilisation de débitmètres précis et coûteux est donc superflue.

2) Cette indépendance entre les deux débits permet de choisir un débit de gaz vecteur qui assure une dilution suffisante pour empêcher toute condensation sur les parties froides situées en aval et dispense ainsi du chauffage des canalisations.

3) L'évaporation s'effectuant au voisinage de la cloison poreuse, le débit diffusé est indépendant du niveau de remplissage du premier compartiment.

4) La température à laquelle est porté le premier compartiment peut être supérieure à celle utilisée avec le dispositif de l'art antérieur, car on peut choisir les caractéristiques de l'appareillage telles que la section, la porosité et l'épaisseur de la cloison poreuse, de façon à obtenir le débit voulu de diffusion de la vapeur du composé même lorsque la tension de vapeur de ce composé est élevée à la température ambiante.

5) On évite les fluctuations de pression qui apparaissent avec le dispositif de l'art antérieur en raison du barbotage du gaz vecteur dans la source de composé liquide.

Selon l'invention, on peut aussi régler le débit de diffusion de la vapeur du composé en choisissant de façon appropriée le gaz vecteur utilisé. En effet, le débit varie en fonction du gaz vecteur utilisé qui peut être par exemple de l'argon, de l'azote, de l'hydrogène ou de l'hélium. Ainsi, dans les mêmes conditions de température et avec le même appareillage, le débit diffusé est 3 à 4 fois plus élevé lorsque l'on utilise comme gaz vecteur de l'hydrogène au lieu de l'argon.

Le procédé de l'invention permet ainsi de régler plus facilement à la valeur voulue la pression partielle d'un composé gazeux introduit dans un réacteur d'épitaxie, et il permet d'obtenir de plus une meilleure précision et une meilleure reproductibilité.

Par ailleurs, l'appareillage utilisé est d'un coût plus faible et ce procédé peut s'appliquer à une gamme plus large de composés.

L'invention a également pour objet un dispositif d'obtention d'un courant gazeux contenant un composé à l'état de vapeur caractérisé en ce qu'il comprend:

— une enceinte séparée en un premier et un second compartiment par une cloison poreuse, le premier compartiment étant étanche, apte à contenir ledit composé à l'état liquide et comprenant un élément poreux capable de se charger par capillarité dudit composé à l'état liquide dans ce premier compartiment et d'amener le composé à l'état liquide au voisinage de la cloison poreuse,

— des moyens pour mettre en circulation dans le second compartiment un gaz vecteur capable d'entraîner le composé à l'état de vapeur qui a diffusé au travers de la cloison poreuse du premier compartiment au second compartiment, et

— des moyens pour porter et maintenir à une température déterminée le premier compartiment de l'enceinte.

De préférence, l'élément poreux est réalisé en le même matériau que la cloison poreuse, par exemple en silice, en acier inoxydable ou en verre au borosilicate.

On peut utiliser tout autre matériau compatible avec le composé et le gaz vecteur. Par ailleurs, on peut réaliser l'enceinte dans un matériau non poreux du même type.

Pour la cloison et l'élément poreux, on choisit un matériau dont les caractéristiques de porosité permettent l'établissement d'un régime de diffusion pure.

Selon l'invention, les caractéristiques géométriques de la cloison poreuse, c'est-à-dire sa section et son épaisseur, ainsi que ses caractéristiques de porosité sont choisies également en fonction du composé.

Lorsque le composé est un composé organométallique tel que le triméthylindium ou le triméthylgallium, on peut utiliser une cloison poreuse en verre fritté tel que les verres commercialisés sous la marque Pyrex ayant des porosités de 1 à 5.

Selon l'invention, les moyens pour mettre en circulation le gaz vecteur dans le second compartiment comprennent avantageusement une première conduite d'introduction de gaz vecteur et une seconde conduite d'extraction du gaz vecteur contenant le composé à l'état de vapeur, la seconde conduite débouchant dans le second compartiment au voisinage de la cloison poreuse.

Le dispositif de l'invention peut être utilisé en particulier dans un dispositif d'épitaxie en phase vapeur comprenant un réacteur d'épitaxie pour introduire dans ce réacteur au moins l'un des réactifs à l'état gazeux, par exemple des composés organométalliques tels que le triméthylindium et le triméthylgallium.

D'autres caractéristiques et avantages de l'invention apparaîtront mieux à la lecture de la description qui suit, donnée à titre illustratif et non limitatif, en référence au dessin annexé sur lequel:

— la figure 1, qui a été décrite précédemment, représente un dispositif selon l'art antérieur, et

— la figure 2 représente en coupe verticale un dispositif selon l'invention.

Sur la figure 2, on voit que le dispositif de l'invention comprend une enceinte étanche 21 qui est séparée en deux compartiments 21a et 21b par une cloison poreuse 23. Le premier compartiment 21a est destiné à recevoir le composé à évaporer et à introduire dans le courant gazeux, et il est muni d'un élément poreux 25 capable de se charger par capillarité du composé à l'état liquide, disposé dans le compartiment 21a de façon à amener ce composé à l'état liquide au voisinage de la cloison poreuse 23. Le second compartiment est relié par une première conduite d'introduction de gaz 27 munie d'une vanne 29 à une source de gaz vecteur (non représentée sur le dessin), et le gaz vecteur peut être extrait de ce second compartiment par une seconde conduite d'extraction 31 munie de la vanne 33 qui débouche dans le compartiment 21b au voisinage de la cloison poreuse 23. Le dispositif comprend de plus un bain thermostaté 35 permettant de maintenir à la température voulue le premier compartiment 21a de l'enceinte. Comme représenté en tirets sur la figure 2, on peut aussi maintenir les deux compartiments de l'enceinte 21 à la même température en faisant circuler autour de ceux-ci, un liquide thermostaté par les conduites 37 et 39.

Le fonctionnement de ce dispositif est le suivant.

On introduit tout d'abord dans le premier compartiment 21a le composé à évaporer. Ceci peut être effectué directement par remplissage lorsque le compartiment 21a comporte une ouverture latérale qui peut être obturée ensuite de façon étanche. On peut aussi réaliser ce remplissage par distillation sous vide au travers de la vanne 29 en refroidissant les deux compartiments de l'enceinte 21 et en transférant à l'état liquide, toujours sous vide, le composé du compartiment 21b vers le compartiment 21a. Après cette phase de remplissage, on porte le premier compartiment à la température voulue et on met en circulation le gaz vecteur dans le compartiment 21b par ouverture des vannes 29 et 33 et réglage de la vanne 29 au débit voulu.

Dans ces conditions, le composé qui est amené par l'élément 25 au niveau de la cloison poreuse 23 s'évapore au niveau de cette cloison, puis il diffuse au travers de la cloison poreuse 23 dans le compar-

timent 21b où il est entraîné par le gaz vecteur mis en circulation dans ce compartiment et évacué de ce compartiment par la conduite 31.

Dans un tel dispositif, le débit du composé évaporé qui diffuse au travers de la cloison 23 dépend uniquement de la température qui agit à la fois sur la tension de vapeur du composé et sur le coefficient de diffusion de ce composé dans le gaz vecteur.

Ce débit augmente avec la température, proportionnellement au produit de la tension de vapeur du composé par le coefficient de diffusion de cette vapeur dans le gaz vecteur.

La pression partielle du composé dans le gaz vecteur sortant par la conduite 31 varie avec le débit du gaz vecteur qui est mis en circulation dans le compartiment 21b. Généralement, on choisit un débit de gaz vecteur qui assure une dilution suffisante du composé pour empêcher toute condensation sur les parties froides du dispositif situé en aval et éviter ainsi le chauffage des canalisations.

Les exemples suivants sont donnés bien entendu à titre non limitatif pour illustrer l'invention.

Dans ces exemples, on a utilisé une cloison poreuse 23 constituée par un disque ayant 13 mm de diamètre et 4 mm d'épaisseur, réalisée en verre fritté commercialisé sous le nom Pyrex n°1, ce qui signifie que le diamètre de pore équivalent qui correspond au diamètre d'un canal de section circulaire équivalent au pore le plus gros est de 101 à 160 µm. L'élément 25 est également en verre fritté Pyrex n°1.

Dans un premier exemple, on a obtenu un courant d'argon chargé de triméthylindium en opérant à une température de 90,5°C avec un débit d'argon dans le second compartiment 21b de 100 ml.min$^{-1}$. Dans ces conditions, on a obtenu à la sortie du dispositif un débit de triméthylindium de 0,9 mmole.h$^{-1}$.

Dans un deuxième exemple, on a obtenu un courant gazeux d'argon contenant du triméthylgallium en opérant à une température de 18°C avec un débit d'argon de 100 ml.min$^{-1}$. Dans ces conditions, le débit de triméthylgallium sortant du dispositif était de 0,94 mmole.h$^{-1}$.

## Revendications

1. Procédé d'obtention d'un courant gazeux contenant un composé à l'état de vapeur caractérisé en ce qu'il consiste:

a) à introduire le composé dans le premier compartiment (21a) d'une enceinte (21) séparée en un premier et un second compartiment par une cloison poreuse (23),

b) à porter à une température déterminée le premier compartiment de l'enceinte de façon à évaporer ledit composé,

c) à mettre en circulation dans le second compartiment (21b) un gaz vecteur capable d'entraîner le composé évaporé, et

d) à extraire du second compartiment le gaz vecteur contenant le composé évaporé qui a diffusé dans le second compartiment par passage au travers de la paroi poreuse.

2. Procédé selon la revendication 1, caractérisé en ce que le gaz vecteur est choisi parmi l'argon, l'azote, l'hydrogène et l'hélium.

3. Procédé selon l'une quelconque des revendications 1 et 2, caractérisé en ce que le composé est un composé organométallique.

4. Procédé selon la revendication 3, caractérisé en ce que le composé organométallique est le triméthylgallium ou le triméthylindium.

5. Dispositif d'obtention d'un courant gazeux contenant un composé à l'état de vapeur, caractérisé en ce qu'il comprend:

– une enceinte (21) séparée en un premier et un second compartiment par une cloison poreuse (23), le premier compartiment (21a) étant étanche, apte à contenir ledit composé à l'état liquide et comprenant un élément poreux (25) capable de se charger par capillarité dudit composé à l'état liquide dans ce premier compartiment et d'amener le composé à l'état liquide au voisinage de la cloison poreuse (23),

– des moyens (27, 29, 31, 33) pour mettre en circulation dans le second compartiment (21b) un gaz vecteur capable d'entraîner le composé à l'état de vapeur qui a diffusé au travers de la cloison poreuse (23) du premier compartiment au second compartiment, et

– des moyens (35, 35') pour porter et maintenir à une température déterminée le premier compartiment de l'enceinte.

6. Dispositif selon la revendication 5, caractérisé en ce que l'élément poreux (25) est réalisé en le même matériau que la cloison poreuse.

7. Dispositif selon l'une quelconque des revendications 5 et 6, caractérisé en ce que la cloison poreuse (23) est réalisée en un matériau choisi parmi la silice, l'acier inoxydable et le verre au borosilicate.

8. Dispositif selon l'une quelconque des revendications 5 à 7, caractérisé en ce qu'il comprend des moyens (35) pour porter et maintenir à la même température les deux compartiments de l'enceinte.

9. Dispositif selon l'une quelconque des revendications 5 à 8, caractérisé en ce que les moyens pour mettre en circulation le gaz vecteur dans le second compartiment comprennent une première conduite (27) d'introduction du gaz vecteur et une seconde conduite (31) d'extraction du gaz vecteur contenant le composé à l'état de vapeur, la seconde conduite débouchant dans le second compartiment au voisinage de la cloison poreuse (23).

10. Dispositif d'épitaxie en phase vapeur comprenant un réacteur d'épitaxie et des moyens pour introduire dans ce réacteur des réactifs à l'état gazeux, caractérisé en ce que les moyens pour introduire dans le réacteur d'épitaxie l'un au moins desdits réactifs à l'état gazeux sont constitués par un dispositif selon l'une quelconque des revendications 5 à 9.

## Patentansprüche

1. Verfahren zur Gewinnung eines eine Verbindung in dampfförmigem Zustand enthaltenden Gasstromes, dadurch gekennzeichnet, daß es darin besteht, daß man

a) die Verbindung in das erste Abteil (21a) eines Behälters (21) einführt, der durch eine poröse Trennwand (23) in ein erstes Abteil und in ein zweites Abteil unterteilt ist,

b) das erste Abteil des Behälters auf eine vorgegebene Temperatur bringt, um die Verbindung zu verdampfen,

c) in dem zweiten Abteil (21b) ein Trägergas zirkulieren läßt, das die verdampfte Verbindung mitnehmen kann, und

d) aus dem zweiten Abteil das Trägergas abzieht, das die verdampfte Verbindung enthält, die durch Hindurchgang durch die poröse Wand in das zweite Abteil diffundiert ist.

2. Verfahren nach Anspruch 1, dadurch gekennzeichnet, daß das Trägergas ausgewählt wird aus Argon, Stickstoff, Wasserstoff und Helium.

3. Verfahren nach einem der Ansprüche 1 und 2, dadurch gekennzeichnet, daß die Verbindung eine metallorganische Verbindung ist.

4. Verfahren nach Anspruch 3, dadurch gekennzeichnet, daß die metallorganische Verbindung Trimethylgallium oder Trimethylindium ist.

5. Vorrichtung zur Gewinnung eines eine Verbindung in dampfförmigem Zustand enthaltenden Gasstromes, dadurch gekennzeichnet, daß sie umfaßt:

− einen Behälter (21), der durch eine poröse Trennwand (23) in ein erstes Abteil (21a) und in ein zweites Abteil unterteilt ist, wobei das erste Abteil (21a) dicht ist, so daß es die Verbindung in flüssigem Zustand aufnehmen kann und ein poröses Element (25) enthält, das sich durch Kapillarwirkung mit der Verbindung in flüssigem Zustand in dem ersten Abteil beladen kann und die Verbindung in flüssigem Zustand in die Nähe der porösen Trennwand (23) bringen kann,

− Einrichtungen (27, 29, 31, 33), um in dem zweiten Abteil (21b) ein Trägergas in Zirkulation zu versetzen, das die Verbindung in dampfförmigem Zustand mitnehmen kann, die durch die poröse Trennwand (23) des ersten Abteils in das zweite Abteil diffundiert ist, und

− Einrichtungen (35, 35'), um das erste Abteil des Behälters auf eine vorgegebene Temperatur zu bringen und sie dabei zu halten.

6. Vorrichtung nach Anspruch 5, dadurch gekennzeichnet, daß das poröse Element (25) aus dem gleichen Material wie die poröse Trennwand besteht.

7. Vorrichtung nach einem der Ansprüche 5 und 6, dadurch gekennzeichnet, daß die poröse Trennwand (23) aus einem Material besteht, das ausgewählt wird aus Siliciumoxid, rostfreiem Stahl und Borsilikatglas.

8. Vorrichtung nach einem der Ansprüche 5 bis 7, dadurch gekennzeichnet, daß sie Einrichtungen (35) umfaßt, um die beiden Abteile des Behälters auf die gleiche Temperatur zu bringen und sie dabei zu halten.

9. Vorrichtung nach einem der Ansprüche 5 bis 8, dadurch gekennzeichnet, daß die Einrichtungen, um das Trägergas in dem zweiten Abteil in Zirkulation zu versetzen, umfassen eine erste Rohrleitung (27) zur Einführung des Trägergases und eine zweite Rohrleitung (31) zum Abzug des die Verbindung im dampfförmigen Zustand enthaltenden Trägergases, wobei die zweite Rohrleitung in der Nähe der porösen Trennwand (23) in das zweite Abteil mündet.

10. Dampfphasen-Epitaxie-Vorrichtung, die umfaßt einen Epitaxie-Reaktor und Einrichtungen zur Einführung von Reagentien im gasförmigen Zustand in diesen Reaktor, dadurch gekennzeichnet, daß die Einrichtungen zur Einführung mindestens eines der genannten Reagentien im gasförmigen Zustand in den Epitaxie-Reaktor aus einer Vorrichtung nach einem der Ansprüche 5 bis 9 bestehen.

## Claims

1. Process for obtaining a gaseous stream containing a compound in the vapour state, characterized in that it comprises:

a) introducing the compound into the first compartment (21a) of an enclosure (21) subdivided into a first and a second compartment by a porous partition (23),

b) raising the first compartment of the enclosure to a predetermined temperature in order to evaporate said compound,

c) circulating in the second compartment (21b) a carrier gas able to entrain the evaporated compound, and

d) extracting from the second compartment the carrier gas containing the evaporated compound, which has diffused into the second compartment by passing through the porous wall.

2. Process according to claim 1, characterized in that the carrier gas is chosen from among argon, nitrogen, hydrogen and helium.

3. Process according to either of the claims 1 and 2, characterized in that the compound is an organometallic compound.

4. Process according to claim 3, characterized in that the organometallic compound is trimethyl gallium or trimethyl indium.

5. Apparatus for obtaining a gaseous stream containing a compound in the vapour state, characterized in that it comprises

− a tight enclosure (21) subdivided into first and second compartments by a porous partition (23), the first compartment (21a) being tight and able to contain said compound in the liquid state and comprising a porous element (25) which can be charged by capillarity with said compound in the liquid state in said first compartment and which can bring the compound in the liquid state into the vicinity of the porous partition (23),

− means (27, 29, 31, 33) for bringing about the circulation in the second compartment (21b) of a vector gas able to entrain the compound in the vapour state, which has diffused through the porous wall (23) from the first compartment into the second compartment and

− means (35, 35') for raising and maintaining the first compartment at a given temperature.

6. Apparatus according to either of the claims 5 and 6, characterized in that the porous element (25) is made from the same material as the porous partition.

7. Apparatus according to either of the claims 5 and 6, characterized in that the porous partition (23) is made from a material chosen from among silica, stainless steel and borosilicate glass.

8. Apparatus according to any one of the claims 5 to 7, characterized in that it comprises means (35) for raising and maintaining at the same temperature the two compartments of the enclosure.

9. Apparatus according to any one of the claims 5 to 8, characterized in that the means for circulating the carrier gas in the second compartment comprise a first pipe (27) for introducing the carrier gas and a second pipe (31) for extracting the carrier gas containing compound in the vapour state, the second pipe issuing into the second compartment in the vicinity of the porous partition (23).

10. Vapour phase epitaxy apparatus comprising an epitaxy reactor and means for introducing into the latter reagents in the gaseous state, characterized in that the means for introducing at least one of said reagents in the gaseous state into the epitaxy reactor are constituted by an apparatus according to any one of the claims 5 to 9.

FIG.1

FIG.2